Europäisches Patentamt

European Patent Office

Office européen des brevets

(11) Publication number: **0 261 347 B1**

# EUROPEAN PATENT SPECIFICATION

(45) Date of publication of patent specification: **15.01.92**  (51) Int. Cl.⁵: **H01J  37/32**, H01L 21/302,
C23F 1/08, C23C 14/14

(21) Application number: **87110914.6**

(22) Date of filing: **28.07.87**

㊳ Prierity: **27.08.86 US 900959**

(43) Date of publication of application:
**30.03.88 Bulletin  88/13**

(45) Publication of the grant of the patent:
**15.01.92 Bulletin  92/03**

(84) Designated Contracting States:
**DE FR GB**

(56) References cited:
**EP-A- 0 139 835**
**EP-A- 0 180 020**
**EP-B- 0 003 020**
**US-A- 3 617 459**

**PATENT ABSTRACTS OF JAPAN; unexamined applications, E section, vol. 9, no. 211, August 29, 1985 THE PATENT OFFICE JAPANESE GOVERNMENT page 42 C 300**

**PATENT ABSTRACTS OF JAPAN, unexamined applications, E section, vol. 9, no. 196, August 13, 1985 THE PATENT OFFICE JAPANESE GOVERNMENT page 18 C 297**

(73) Proprietor: **International Business Machines Corporation**
**Old Orchard Road**
**Armonk, N.Y. 10504(US)**

(72) Inventor: **Jones, Fletcher**
**29 Linden Avenue**
**Ossining New York 10562(US)**
Inventor: **Logan, Joseph Skinner**
**14 Highpoint Drive**
**Poughkeepsie New York 12603(US)**

(74) Representative: **Mönig, Anton, Dipl.-Ing.**
**IBM Deutschland GmbH Patentwesen und Urheberrecht Schönaicher Strasse 220**
**W-7030 Böblingen(DE)**

(54) Sputtering apparatus.

Note: Within nine months from the publication of the mention of the grant of the European patent, any person may give notice to the European Patent Office of opposition to the European patent granted. Notice of opposition shall be filed in a written reasoned statement. It shall not be deemed to have been filed until the opposition fee has been paid (Art. 99(1) European patent convention).

**Description**

The present invention relates to radio frequency (RF) sputtering systems for etching and/or depositing material.

RF sputtering is a well known technique in the art of dry process etching and deposition. In brief, it is a type of diode sputtering with a cathode electrode, an effective anode, and a plasma within a vacuum chamber. The electrodes are typically driven at high voltage (600-1500 volts) and high frequency (13.56 megahertz). The plasma is formed by the high voltage induced breakdown of the gas in the chamber, and typically assumes a small positive potential relative to ground, which is the potential of the chamber walls. All electrodes develop a negative dc bias with respect to the plasma. However, the cathode is usually smaller than the anode so that a high negative dc bias is developed on it with respect to the plasma. The cathode electrode is bombarded at high energy by ions in the plasma during the "negative" portion of the applied voltage and by electrons during the "positive" part. Thus, no net charge flows through the cathode electrode. The cathode electrode is sputtered by the high energy ion bombardment. This sputtering is used either for erosion of samples on the cathode surface, or net deposition on samples placed on an opposing surface with suitable support. For a more detailed discussion of RF sputtering, one can refer to B. Chapman, "Glow Discharge Process," J. Wiley and Sons, N.Y. 1980, pp. 135-173.

Current manufacturing capability for depositing sputtered $SiO_2$ on semiconductor device wafers has evolved from small batch tools to very large batch tools capable of holding as many as 20 - 82 mm dia. wafers. In these very large batch tools, the $SiO_2$ target diameter may be as large as 61 cm (24 in.) and deposition run times are approximately 5 to 6 hours at a deposition rate of 25 nm/min. for "standard" $SiO_2$ and 12.5 nm/min. for "planar" $SiO_2$. Long cycle times, plus the necessity of batching wafers makes this operation expensive and logistically difficult for manufacturing.

However, development of a single wafer tool, with comparable through-put to the batch wafer tools, requires a tool with a deposition rate of about 20 times as the rate for current batch tools. This is a deposition rate of approximately 500 nm/min.

Such high rate diode sputtering of $SiO_2$ has been reported by Grantham et al, Journal of Vacuum Science Technology, Volume 7, pp. 343 (1970). This unit used a strong axial magnetic field, differential pumping of the cathode insulator and RF power density of about $50w/cm^2$ to achieve deposition rate of about 500 nm/min. However, at such high target sheath voltages and power densities, sputtering efficiencies are known to be low and losses very high. Furthermore, such use of magnetic fields causes radial non-uniformity.

To obtain the sought after high deposition rates in an efficient process for use in manufacturing, it is necessary to obtain significantly higher plasma density than is conventionally achievable with known diode RF discharges. In addition, with such high deposition rates, the apparatus must be designed to reduce accumulation of material in the chamber which can cause particulate contamination of the wafer.

In the art of radio frequency (RF) sputter deposition, one technique for control of the degree of resputtering of the substrate electrode in a diode (two-electrode) system has been by varying the ratio of source electrode area to substrate electrode area (Koenig and Maissel, IBM Journal Res. & Dev., Vol. 14, No. 2, March 1970, pp. 168-171.). This, in principle, will allow adjustment of the substrate material balance from deposition to etching. However, unless one is using the entire substrate area for useful material collection, part of the substrate area must be periodically cleaned and will be potentially a source of particulates. This has been also true, in general, for the 3-electrode systems controlled by substrate-tuning (see U. S. Patent No. 3,617,459), or by control using a separate source of RF power. Here, material collects on the third or "wall" electrode, as well as on unused portions of the substrate electrode.

A different apparatus known in the prior art for high plasma density by geometrical confinement has been the RF hollow-cathode, which has been used for reactive ion etching.

In U. S. Patent No. 4,521,286 issued to Horowitz on June 4, 1985 and assigned to Unisearch Limited of Kensington, Australia, one type of RF hollow cathode sputter etcher is taught for controlling the speed and directionality of the plasma in a chemically reactive process. However, this is a chemically reactive process, and the etched silicon (Si) is pumped out of the chamber with the other etch products combined with the reactive gas. Wherein, the removal of silicon by reactive gas is inapplicable to physical sputtering and there is no teaching for controlling material accumulation on the chamber walls.

It is therefore an object of the present invention to provide a physical sputter etcher and deposition apparatus wherein very high etching deposition rates can be achieved at low voltage or high plasma density.

It is a further object of the present invention that the design of the chamber of the apparatus is such that material accumulation on the walls of said chamber is greatly reduced or reduced to the point of being removed entirely.

It is another object of the present invention to provide a low contamination, high deposition rate sputtering apparatus for the etching and deposition of insulator films, of such materials as $SiO_2$ on semiconductor device wafers.

It is a still further object of the present invention that the plasma potential within the chamber be controlled so that re-sputtering of the substrate can be controlled.

These objects are achieved by sputtering apparatus as disclosed in claims 1 and 5.

Said additional electrode can be made to be coplanar with said other electrodes.

Thick insulator rings are used to reduce stray capacitance between the additional electrode and ground whereby the outer chamber (normally grounded) forms a low inductance path between the target electrode and substrate electrode and acts as a shield for the inner chamber RF potential.

In the embodiment of claim 1, the in-phase mode, preferably the substrate voltage is adjusted with respect to the target voltage by a variable capacitor, between the substrate electrode and the target electrode.

In the embodiment of claim 5, the tuned substrate mode, and an inductive tuned network is used to vary the substrate RF bias voltage with respect to the plasma in order to control resputtering of the substrate.

In the subclaims also other advantageous embodiments of the inventive apparatus are disclosed.

The invention will become more apparent from the following description taken in conjunction with the accompanying drawings.

| | |
|---|---|
| FIG. 1 | shows a schematic of a conventional tuned substrate sputtering system as known in the prior art. |
| FIG. 2 | shows a skeletal schematic cross section of the in-phase sputtering apparatus according to the invention herein. |
| FIG. 3 | shows a skeletal schematic cross section of the tuned substrate sputtering apparatus according to the invention herein. |
| FIG. 4 | shows, a further, more detailed, cross section of the in-phase apparatus of FIG. 2. |
| FIG. 5 | shows a flow calibration curve for the gas introduced into the apparatus of the subject invention. |
| FIG. 6 | is a graph of the measured deposition rates for low and high power resputtering with the in-phase apparatus of FIG. 4. |
| FIG. 7 | is a graph of the measured deposition rates for the tuned substrate system of FIG. 3. |
| FIG. 8 | is a graph of the target sheath voltage versus the system power density for both tuned substrate (diode) and in-phase modes at separate frequencies. |
| FIG. 9 | is a graph of the results of uniformity of film deposit for an in-phase system operating at 0,066 mbar (50 mTorr). |
| FIG. 10 | is a graph of the results of uniformity of film deposit for the apparatus of the tuned substrate of FIG. 3. |
| FIGS. 11.1 and 11.2 | are graphs of the influence of changing the inner diameter of the additional electrode on the thickness distribution of the apparatus of FIG. 4. |
| FIG. 12 | is a graph of $SiO_2$ peak heights over metal linewidths for various substrate voltages in the tuned substrate mode. |

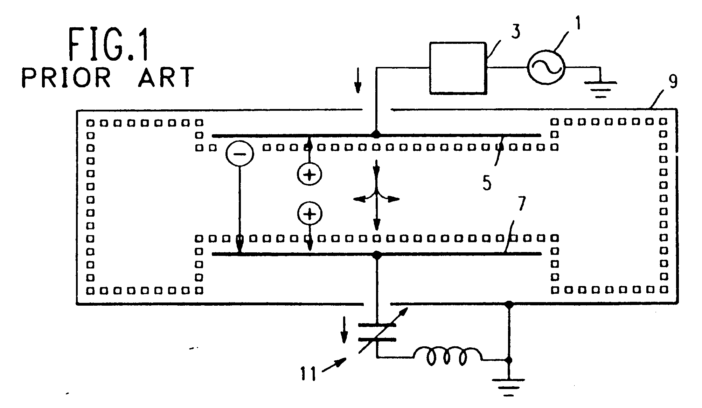

A conventional tuned substrate sputtering system is shown schematically in FIG. 1. The RF generator 1 is connected through an appropriate matching network 3 to the target (top) electrode 5 to which is attached the target material ($SiO_2$). The substrate electrode 7 (bottom) holds the substrate (silicon wafer) (not shown) and is insulated from the chamber 9 which is grounded. The RF current into the system flows through the target electrode 5, into the plasma, and then divides, some flowing into the substrate electrode 7, and the remainder into the wall electrode 9 to ground. An inductive tuned network 11 connects the substrate holder to ground, and is used to vary the substrate RF bias voltage with respect to the plasma in order to control resputtering of the substrate. In this arrangement, the phase of the target and substrate sheath RF voltages is at or near 180 degrees for any condition of resputtering.

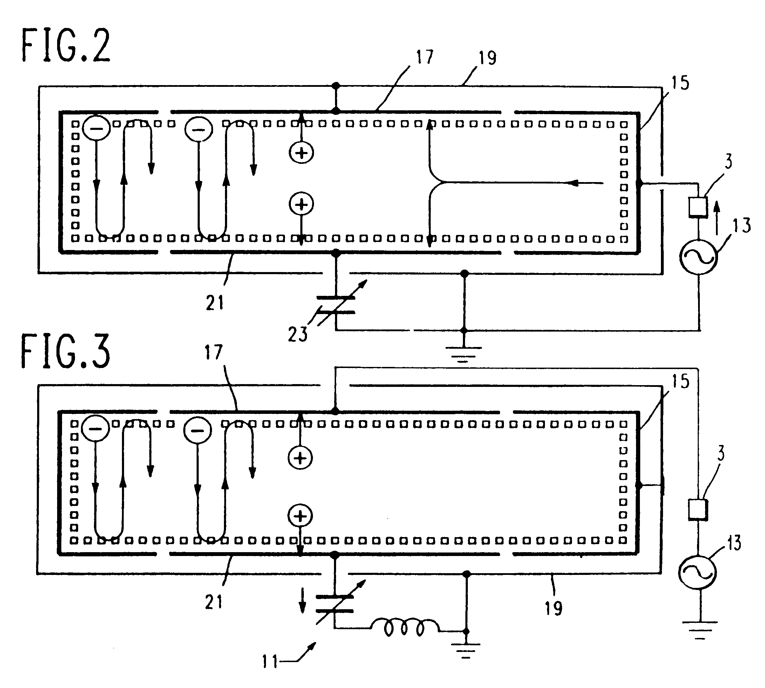

Turning now to the subject invention, FIG. 2 shows a schematic drawing of the in-phase RF sputtering apparatus. As can be seen in FIG. 2, RF power 13 is applied to the cylindrical inner metal annulus called the additional electrode 15. We have chosen to ground the target electrode 17 to the metal vacuum chamber 19, and to insulate the substrate electrode 21 and couple it to ground by a variable capacitor 23. The RF current flow is therefore from the additional electrode 15, into the plasma and then radially inward to

EP 0 261 347 B1

ground through both target 17 and substrate 21 electrodes. Alternatively, one can ground the additional electrode, and drive both target and substrate with the same connection, again using a variable capacitor to adjust substrate coupling. In either case, the phase relationship between target sheath voltage and substrate sheath voltage is near zero for most conditions of resputtering.

As can be seen in the FIG. 2, the additional electrode of the in-phase sputtering system is shaped as a hollow annulus. However, the shape of the additional electrode can be any of a variety of shapes including, but not limited to the annulus shown. The relative areas of the additional electrode (Aw), the target electrode (At), and the substrate electrode (As) are chosen to enhance the sputtering of the wall. For the in-phase mode, the areas follow the approximate relationship Aw is approximately equal to or slightly larger than As + At to cause equal sputtering on the wall and target.

In practice, some additional modification is desirable to compensate for the fact that the substrate sputtering must be less than the target sputtering to obtain a net deposition.

As the substrate capacitance is decreased, less RF current will flow into the substrate electrode, resulting in less substrate self-bias, and less substrate sputter-etching. Therefore, the substrate can accumulate material which has been sputter-etched from the target and the additional electrodes. If the target and the additional electrode are covered with the desired material, say $SiO_2$, then $SiO_2$ can be deposited on the substrate electrode at a controlled level of re-sputtering. Furthermore, the additional and the target electrodes will sputter-etch at approximately the same rate, so that they will have no net accumulation of material.

FIG. 3 shows a skeletal schematic cross section of the tuned substrate sputtering apparatus according to the invention herein. It should be readily apparent that the tuned substrate apparatus of FIG. 3 is mechanically similar in design to the in-phase apparatus of FIG. 2. However, it should be noted that in FIG. 3 the area of the additional electrode is made approximately equal to the substrate electrode and an inductor network has replaced the capacitive network in FIG. 2 and the electrical connections have been changed.

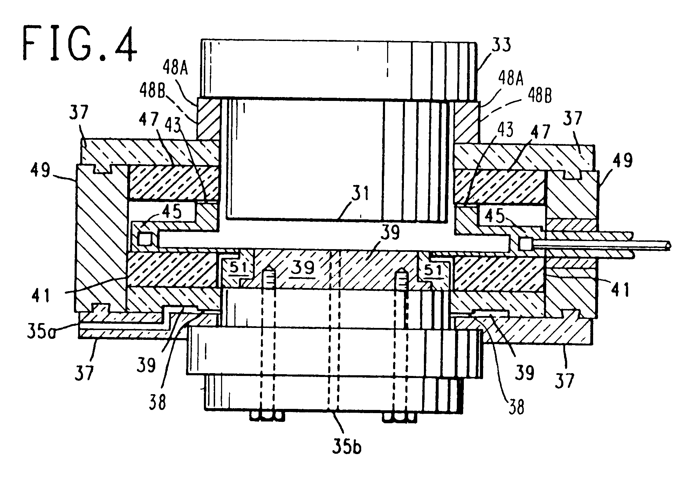

Referring now to FIG. 4, the silica target 31 was a 1.57 mm thick x 150 mm dia. plate (Corning type 7940 optical grade) bonded to a water cooled aluminum target electrode 33 with indium-tin solder. The thickness of the target plate was chosen to limit the surface temperature rise at full power (11.6 watts/cm$^2$ ion heat load) to less than 120 deg. C. A hole through the target electrode structure to the target backside permitted a fiber optic probe to be used for rate monitoring by reflectance of a HeNe laser beam normally incident on the silicon substrate.

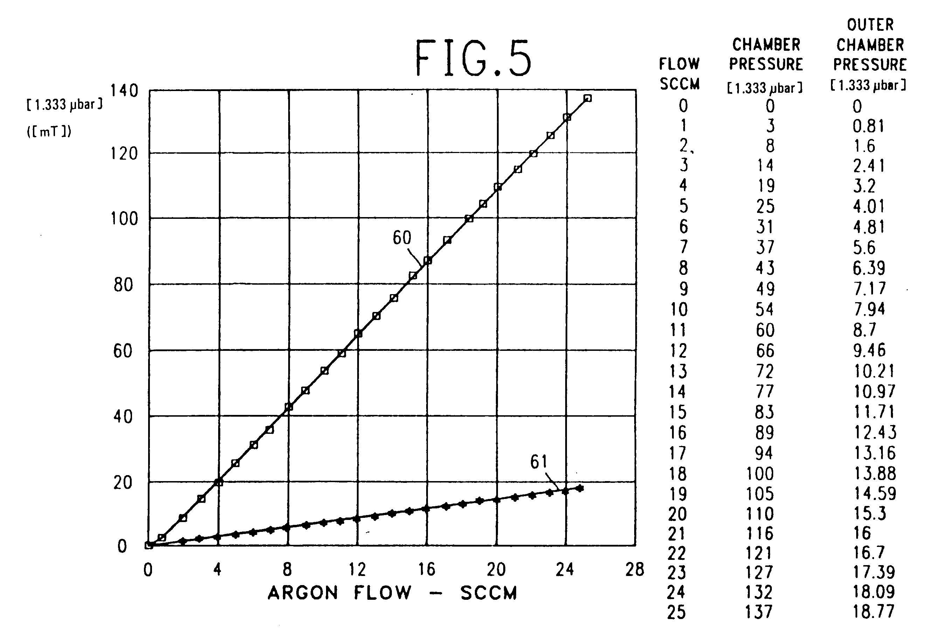

Argon gas is introduced from an inlet 35A on the base plate 37, using a gap 38 into the annular space between the water-cooled substrate electrode 39 and the glass-ceramic lower insulator ring 41. Argon was pumped out of the inner chamber through a 0.5 mm throttling gap 43 between the wall electrode 45 and the glass-ceramic upper insulator ring 47. Using this arrangement, the flow-pressure calibration was measured as shown FIG. 5, graphs 60 and 61; the inner chamber pressure 60 was sensed using the cooling gas port 35b in the substrate holder, without a wafer in place, as shown in FIG. 4.

A channel 35B through the substrate electrode 39 and the anodized plate carried argon gas to the wafer backside. The substrate electrode 39 is further surrounded by insulating ring 51.

The additional electrode 45 was a machined and brazed aluminum assembly supported on four rods (not shown). Member 49 encloses the total apparatus. A large pump port (not shown) is provided through member 49.

For the in-phase mode these rods were insulated from member 49. One of the rods was used to supply the r.f. power to the system, and was water cooled. Two of the rods were used to supply water to cool the wall electrode and also to provide a convenient voltage measuring connection. The target electrode was grounded to member 49 with a metal ring 48A. Member 49 encloses the total apparatus.

For the tuned substrate mode, the four support rods were grounded to member 49 and the target electrode 33 was insulated by a glass ring 48B which replaced metal ring 48A.

The inside diameter of the additional electrode was initially 241 mm, and was later reduced using an insert to 229 mm, giving area ratios (Aw/As + At) of 1.70 and 1.43 respectively in the in-phase mode. These ratios were larger than intended and as a result, the resputtering of the additional electrode in the hollow-cathode mode was not optimized for the data reported herein. All data was taken using a 10 Kw 40.68 MHz r.f. generator from RF plasma products. This frequency was chosen based on a need to obtain the highest possible plasma density at the lowest voltages. All data reported herein for the in-phase mode was for the smallest diameter (229 mm) of the additional electrode. However, in the tuned-substrate mode, additional insert rings were made and tested down to 157 mm dia. giving tuned substrate area ratios (Aw/As) down to 1.04, where substantial wall sputtering was measured.

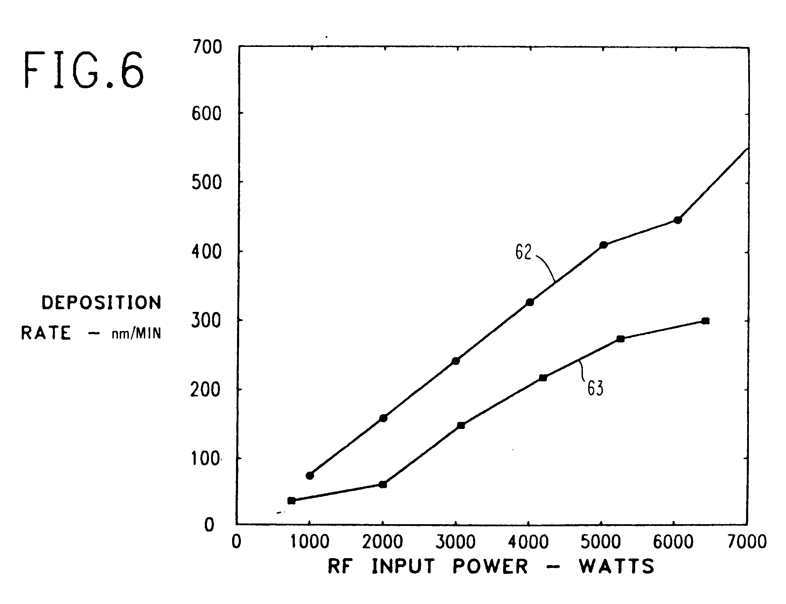

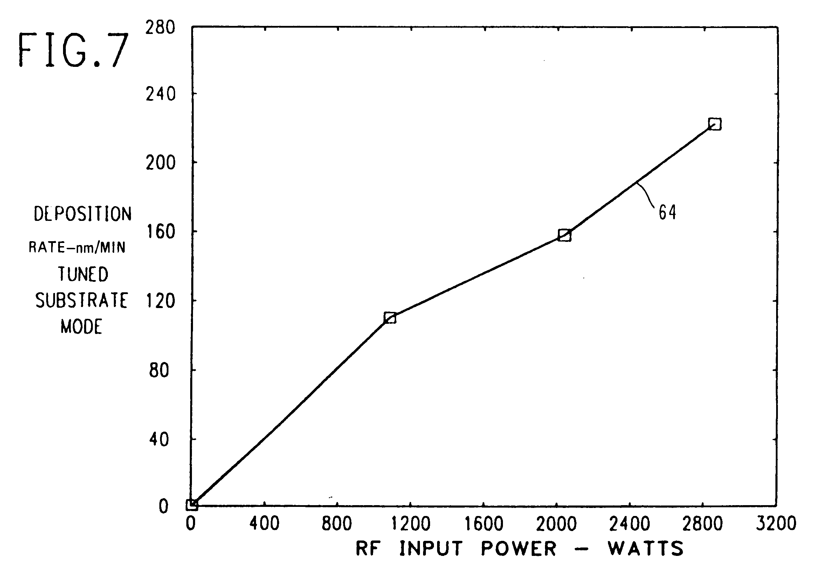

Deposition rates versus power are shown in FIG. 6 for low resputtering level 62 and high resputtering

4

level 63 of resputtering, for both modes. A rate of 500 nm/min was exceeded at 7KW in the in-phase mode, at a low resputtering level. In the tuned-substrate mode FIG. 7, resputtering level 64, the power was not raised as high because of the excessively high system voltages which could exceed ratings of matching network components.

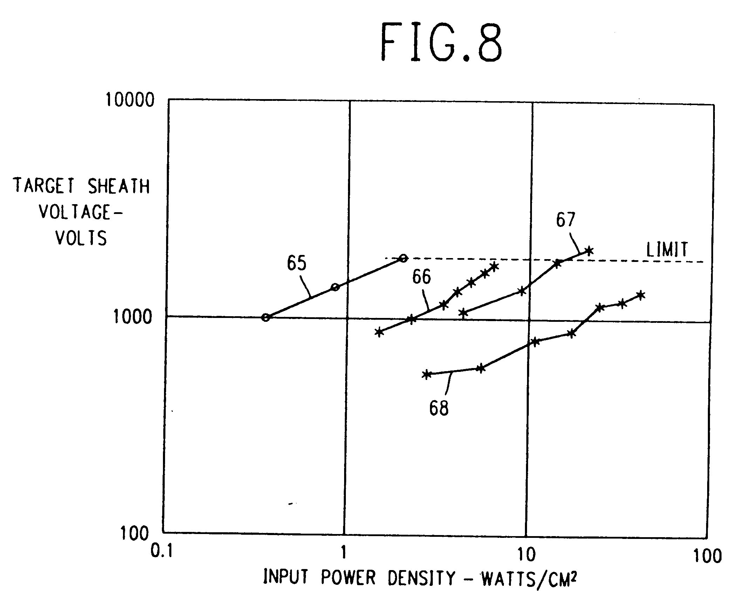

FIG. 8 shows the target sheath voltage vs the total system power density (net rf power divided by target area) for 4 different cases; 13 MHz tuned substrate mode 65 and in-phase mode 66, and 40.68 MHz tuned substrate mode 67 and in-phase mode 68. The use of the highest frequency and the in-phase mode combined gave the lowest voltage/ power density curve, which allowed the use of a power density sufficient to reach the desired rate without exceeding those target sheath voltages currently used by those in the art (approximately 2,000).

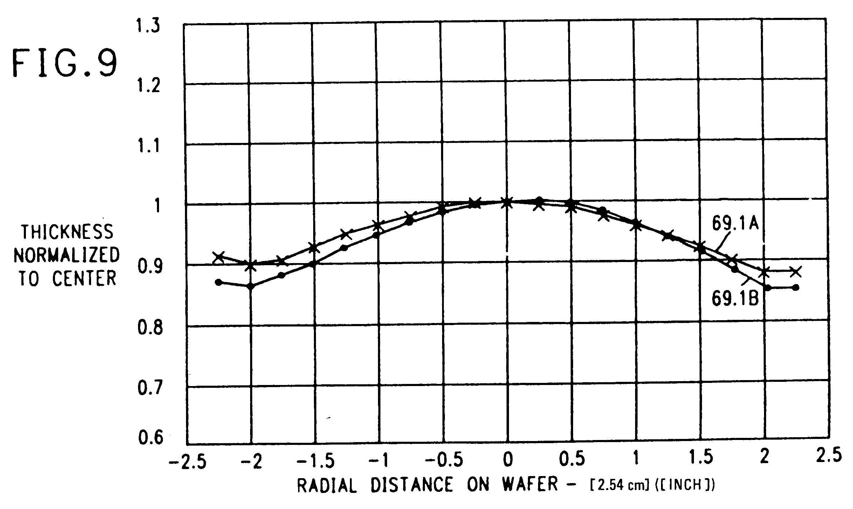

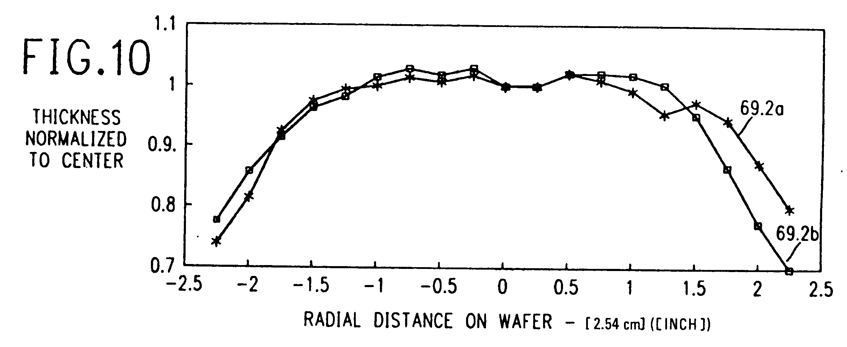

FIGS. 9 and 10 show the thickness distribution for the in-phase 19.05 cm (7.5 inch), inner diameter 69.1A and B and tuned substrate 22.86 cm (9.0 inch), inner diameter modes 69.2A and B, respectively. Both apparatii, used symmetrical target electrode connections under "standard" resputtering conditions at 3KW input power and show a symmetrical thickness profile. The A and B curves represent measurements across the orthogonal axii of the wafer.

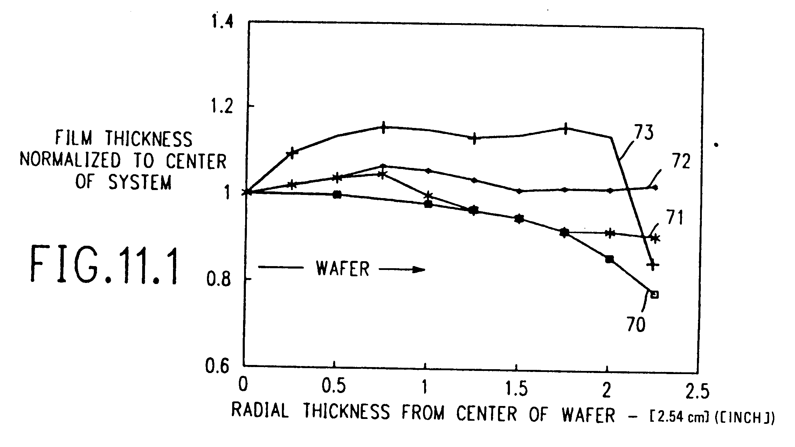

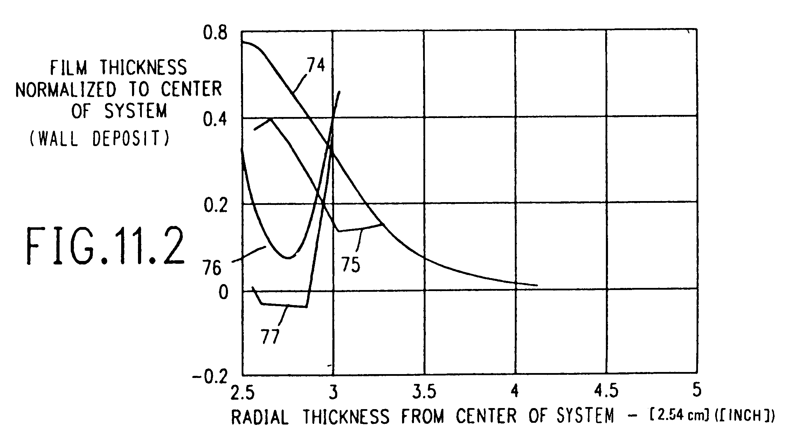

Using the tuned substrate mode, the inner diameter of the additional electrode was changed from 241 mm to 158 mm in four steps. The four steps used resulted in FIG. 11 area ratios (Aw/As) of 5.45 Graphs (70, 74), 1.95 Graphs (71, 75), 1.26 Graphs (72, 76), and 1.04 Graphs (73, 77) respectively. The influence of this change on thickness distribution both on the wafer and on the additional electrode is shown in FIGS. 11.1 and 11.2 and TABLE 1. As the diameter is reduced, the deposit on the wall is reduced and the thickness on the wafer edge is increased. This is due to the expected increase of additional electrode resputtering as the additional electrode area is decreased. At a diameter of the additional electrode of 158mm, the additional electrode itself is being etched in some places. At a diameter of the additional electrode of 163 mm, the wafer thickness profile appears to be nearly ideal, while the additional electrode deposit has been reduced to about 30% at the inner edge, as compared to about 60% for the largest inner diameter.

## TABLE 1

### Tuned Substrate Mode:

| additional electrode I.D. (cm) | Area Ratio Aw/As | additional electrode Max. deposit % of center |
|---|---|---|
| 24,13 | 5.45 | 57% |
| 17,78 | 1.95 | 40% |
| 16,26 | 1.26 | 35% |
| 15,75 | 1.04 | 0% |

### In-Phase Mode:

| additional electrode I.D. (cm) | Area Ratio Aw/At+As | additional electrode Max. deposit % of Center |
|---|---|---|
| 19,05 | 1.05 | 23% |

Stress was measured on some runs by measuring wafer deflection using a stylus profilometer. TABLE 2 contains the data for both rf hollow cathode depositions and for tuned substrate depositions. All stress measurements were compressive. The rf in-phase measurements at 3 different power levels show that there is a trend of decreasing stress with increasing power (deposition rate). During these runs, a backside gas pressure of 1,333 mbar (1 Torr) was used, so that the temperature of the wafer would be expected to increase linearly with power. The measurements for the tuned substrate mode were all at a single power using a 3,999 mbar (3 Torr) cooling gas pressure, with a variable substrate bias voltage (variable resputtering). These values were all below $10^8$ Pa ($10^9$ dynes/cm$^2$), and showed no apparent correlation to resputtering level. This measurement accuracy is estimated to be +/-20%. For comparison, values for these films conventionally deposited usually range between between 1.5 and 2.2 x $10^8$ Pa (1.5 and 2.2 x $10^9$ dynes/cm$^2$). A low compressive stress is usually desirable for mechanical strength.

## TABLE 2

## FILM STRESS

### IN-PHASE MODE - 22.86 cm (9 IN.) I.D. CHAMBER

| POWER (WATTS) | RESPUTTERING | DEPOSITION RATE (nm/MIN.) | BACKSIDE GAS (TORR) | STRESS (X $10^8$ Pa) ((X 10*9 DYNE/CM2)) |
|---|---|---|---|---|
| 1000 | PLANAR | 49.1 | 1 | 3.9 |
| 3000 | PLANAR | 156 | 1 | 1.48 |
| 5000 | PLANAR | 225 | 1 | 1.09 |

### TUNED SUBSTRATE MODE - 22.86 cm (9 IN.) I.D. CHAMBER

| POWER (WATTS) | SUBSTR. BIAS (P-P VOLTS) | DEPOSITION RATE (nm/MIN.) | BACKSIDE GAS (TORR) | STRESS (X $10^8$ Pa) ((X 10*9 DYNE/CM2)) |
|---|---|---|---|---|
| 3000 | 350 | 231.7 | 5 | 0.69 |
| 3000 | 400 | 236.7 | 3 | 0.16 |
| 3000 | 500 | 240.2 | 3 | 0.56 |
| 3000 | 600 | 219 | 3 | 0.63 |
| 3000 | 700 | 193.8 | 3 | 0.20 |
| 3000 | 800 | 177.3 | 3 | 0.70 |

Refractive index is an indicator of both density and stoichiometry. Thermally grown oxide films on silicon are usually used as a reference. TABLE 3 shows the measurements made at 632.8 nm and 546.1 nm using a Rudolph automatic ellipsometer.

TABLE 3

| REFRACTIVE INDEX | | | | |
|---|---|---|---|---|
| TUNED SUBSTRATE MODE - 22.86 cm (9 IN.) I.D. CHAMBER | | | | |
| POWER (WATTS) | SUBSTR. BIAS (VOLTS) | DEPOSITION RATE(nm/MIN.) | REFR. INDEX (632.8 nm) | REFR. INDEX (545.1 nm) |
| 3000 | 400 | 236.7 | 1.459 (9) | 1.467 (16) |
| 3000 | 500 | 240.2 | 1.460 (3) | 1.445 (8) |
| 3000 | 600 | 219 | 1.456 (14) | 1.440 (13) |
| 3000 | 700 | 193.8 | | 1.453 (9) |
| 3000 | 800 | 177.3 | 1.458 (7) | 1.434 (9) |
| Thermal $SiO_2$ | | | 1.457 | 1.460 |

The only films characterized this way were films deposited in the tuned substrate mode at different resputtering levels. A number of readings, shown in parentheses, were averaged to get the values tabulated. The values obtained are reasonably close to values for thermal oxide. Small deviations from stoichiometry can increase the refractive index. Density reduction can reduce the index proportionately. Except for the unlikely event of compensating deviations in stoichiometry and density, the numbers indicate near- bulk property films.

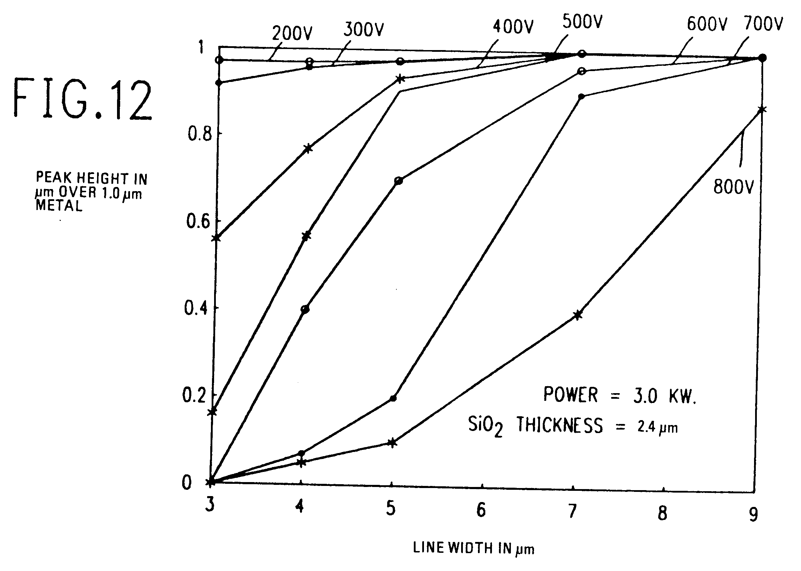

Measurements of $SiO_2$ profile over aluminum metal patterns were made for a series of substrate electrode voltages in the tuned substrate mode only. FIG. 12 shows the peak heights of the $SiO_2$ profile as measured with a SLOAN DEKTAK II profilometer. "Standard" $SiO_2$ conditions would produce no planarization at all, so the 200 V or 300 V curves represent that condition. "Planar" conditions are defined as a peak height of less than 0.2 $\mu$m over a 5 $\mu$m wide line. Clearly, the 700 volt condition or greater satisfies this condition. Therefore, the system can achieve planarity in the tuned substrate mode at 3 KW.

Thus, while the invention has been described with reference to preferred embodiments thereof, it will be understood by those skilled in the art that various changes in form and details may be made without departing from the scope of the invention.

**Claims**

1. A non-reactive RF sputter etching and/or deposition apparatus wherein a source (13) of RF voltage is provided, wherein a vacuum chamber (19) encloses a substrate electrode and a target electrode (21 or 17 respectively) such that said target electrode and substrate electrode are located in a face to face relationship, wherein an additional electrode (15) encircling said target and substrate electrodes (17 or 21 respectively) and the space there between, is provided and wherein a means for supplying and varying RF voltage potentials applied to said target, substrate and additional electrodes (17, 21 or 15 respectively) is provided and wherein said chamber (19) includes means for introducing an ionizable gas into said chamber, characterized in

   - that said additional electrode (15) is separate from said vacuum chamber (19),
   - that said additional electrode (15) has an area approximately equal to or larger than the sum of said target and substrate electrode areas, and
   - that said RF voltage is supplied in a way that the phase relationship between the potentials of said target and substrate electrodes (17 or 21 respectively) is near zero.

2. An RF sputter etching and/or deposition apparatus according to claim 1 wherein the means for varying the magnitude of the substrate RF voltage with respect to the magnitude of the target voltage is a variable capacitor (23).

3. An RF sputter etching and/or deposition apparatus according to claim 1 or 2 wherein the additional electrode (15) is driven from one terminal of an RF generator (13) and the target and substrate electrode (17 or 21 respectively) provide the return path.

4. An RF sputter etching and/or deposition apparatus according to any one of claims 1 to 3 wherein said target electrode (17) and substrate electrode (21) are the driven electrodes and the additional electrode (15) provides the return path.

5. A non-reactive RF sputter etching and/or deposition apparatus wherein a source of RF voltage (13) is provided, wherein a vacuum chamber (19) encloses a substrate electrode and a target electrode (21 or 17 respectively) such that said target and substrate electrodes are located in a face to face relationship, wherein an additional electrode (15) encircling said target and substrate electrodes (17 or 21 respectively) and the space there between is provided and wherein a means for supplying and varying RF voltage potentials applied to said target, substrate and additional electrodes (17, 21 or 15 respectively) is provided and wherein said chamber (19) includes means for introducing an ionizable gas into said chamber, characterized in

- that said additional electrode (15) is separate from said vacuum chamber (19),
- that said additional electrode (15) has an area approximately equal to said substrate electrode (21) area, and
- that said RF voltage is supplied in a way that the phase relationship between the potentials of said target and substrate electrodes (17 or 21 respectively) is near 180°.

6. An RF sputter etching and/or deposition apparatus according to claim 5 wherein the means for varying the magnitude of the substrate RF voltage with respect to the magnitude of the target electrode voltage is an inductive network (11).

7. An RF sputter etching and/or deposition apparatus according to claim 5 or 6 wherein the additional electrode (15) and the substrate electrode (21) are driven from one terminal of an RF generator (13) and the target electrode (17) provides the return path.

8. An RF sputter etching and/or deposition apparatus according to any one of claims 5 to 7 wherein said target electrode (17) is the driven electrode and the substrate electrode (21) and additional electrode (15) provide the return path.

9. An RF sputter etching and/or deposition apparatus according to any one of claims 1 to 8 wherein the means for introducing the gas flow into said vacuum chamber (19) is from a circular manifold surrounding the substrate electrode (21).

10. An RF sputter etching and/or deposition apparatus according to claim 1 wherein the gas to be introduced into said vacuum chamber (19) is selected from the group of noble gases, preferably from the group of argon, xenon or krypton.

**Revendications**

1. Dispositif de gravure et/ou dépôt par pulvérisation HF non réactive dans lequel une source (13) de tension HF est prévue, dans lequel une chambre à vide (19) renferme une électrode de substrat et une électrode de cible (21 ou 17 respectivement) de façon telle que ladite électrode de cible et ladite électrode de substrat sont situées l'une en face de l'autre, dans lequel une électrode supplémentaire (15) entourant lesdites électrodes de cible et de substrat (17 ou 21 respectivement) et l'espace entre celles-ci, est prévue et dans lequel un moyen pour délivrer et faire varier le potentiel de tension HF appliqué auxdites électrodes de cible, de substrat et supplémentaire (17, 21 ou 15 respectivement), est prévu et dans lequel ladite chambre (19) comporte un moyen pour introduire un gaz ionisable dans ladite chambre, caractérisé en ce que
- ladite électrode supplémentaire (15) est séparée de ladite chambre à vide (19) ;
- ladite électrode supplémentaire (15) a une surface approximativement égale ou supérieure à la somme des surfaces des électrodes de cible et de substrat, et
- ladite tension HF est délivrée d'une manière telle que la relation de phase entre les potentiels des électrodes de cible et de substrat (17 ou 21 respectivement) est près de zéro.

2. Dispositif de gravure et/ou de dépôt par pulvérisation HF selon la revendication 1, dans lequel le moyen pour faire varier l'amplitude de la tension HF du substrat par rapport à l'amplitude de la tension de cible est un condensateur variable (23).

3. Dispositif de gravure et/ou de dépôt par pulvérisation HF selon la revendication 1 ou 2, dans lequel l'électrode supplémentaire (15) est excitée depuis une borne d,un générateur HF (13) et les électrodes de cible et de substrat (17 ou 21 respectivement) procurent le trajet de retour.

4. Dispositif de gravure et/ou de dépôt par pulvérisation HF selon l'une quelconque des revendications 1 à 3, dans lequel ladite électrode de cible (17) et ladite électrode de substrat (21) sont des électrodes excitées et l'électrode supplémentaire (15) procure le trajet du retour.

5. Dispositif de gravure et/ou de dépôt par pulvérisation HF non réactive dans lequel une source de tension HF (13) est prévue, dans lequel une chambre à vide (19) renferme une électrode de substrat et une électrode de cible (21 ou 17 respectivement), de manière telle que lesdites électrodes de cible et de substrat sont situées l'une en face de l'autre, dans lequel une électrode supplémentaire (15) entourant lesdites électrodes de cible et de substrat (17 ou 21 respectivement), et l'espace entre celles-ci est prévue, et dans lequel un moyen pour délivrer et faire varier le potentiel de tension HF appliqué auxdites électrodes de cible, de substrat et supplémentaire (17, 21 ou 15 respectivement) est prévu et dans lequel ladite chambre (19) comporte un moyen pour introduire un gaz ionisable dans ladite chambre, caractérisé en ce que
   - ladite électrode supplémentaire (15) est séparée de ladite chambre à vide (19) ;
   - ladite électrode supplémentaire (15) présente une surface approximativement égale à la surface (21) de l électrode de substrat, et
   - ladité tension HF est délivrée d'une manière telle que la relation de phase entre le potentiel des électrodes de cible et de substrat (17 ou 21 respectivement) est proche de 180$^\circ$.

6. Dispositif de gravure et/ou de dépôt par pulvérisation HF selon la revendication 5, dans lequel le moyen pour faire varier l'amplitude de la tension HF du substrat par rapport à l'amplitude de la tension de l'électrode de cible est un réseau inductif (11).

7. Dispositif de gravure et/ou de dépôt par pulvérisation HF selon la revendication 5 ou 6, dans lequel l'électrode supplémentaire (15) et l'électrode de substrat (21) sont excitées depuis une borne d'un générateur HF (13) et l'électrode de cible (17) procure le trajet de retour.

8. Dispositif de gravure et/ou de dépôt par pulvérisation HF selon l'une quelconque des revendications 5 à 7, dans lequel ladite électrode de cible (17) est l'électrode excitée et l'électrode de substrat (21) et l'électrode supplémentaire (15) procurent le trajet de retour.

9. Dispositif de gravure et/ou de dépôt par pulvérisation HF selon l'une quelconque des revendications 1 à 8, dans lequel le moyen pour introduire le gaz circulant dans ladite chambre à vide (19) est un collecteur circulaire entourant l'électrode de substrat (21).

10. Dispositif de gravure et/ou de dépôt par pulvérisation HF selon la revendication 1, dans lequel le gaz qui doit être introduit dans ladite chambre à vide (19) est sélectionné dans le groupe des gaz nobles, de préférence dans le groupe de l'argon, xénon ou krypton.

**Patentansprüche**

1. Ein nicht-reaktives ionenätzendes und/oder durch Zerstäuben beschichtendes RF Gerät mit einer RF Spannungsquelle (13), einer Vakuumkammer (19), die eine Substratelektrode und eine Quellenelektrode (21 oder 17) so umschließt, daß die Quellenelektrode und die Substratelektrode sich gegenüberliegen, einer zusätzlichen Elektrode (15), die die Quellen- und Substratelektroden (17 oder 21) und den Raum zwischen ihnen umgibt, Mitteln zum Versorgen mit und ändern von RF Spannungspotentialen, die an die Quellenelektrode, Substratelektrode und zusätzliche Elektrode (17, 21 oder 15) angelegt sind und wobei die Kammer (19) Mittel zum Einführen eines ionisierbaren Gases in die Kammer enthält, dadurch gekennzeichnet daß:

   - die zusätzliche Elektrode (15) getrennt ist von der Vakuumkammer (19)
   - die zusätzliche Elektrode (15) eine Fläche besitzt, die ungefähr gleich oder größer ist als die Summe der Flächen der Quellen- und Substratelektroden und
   - die besagte RF Spannung so angelegt ist, daß die Phasenbeziehung zwischen den Potentialen

EP 0 261 347 B1

der Quellen- und Substratelektroden (17 oder 21) fast Null ist.

**2.** Ein ionenätzendes und/oder durch Zerstäuben beschichtendes RF Gerät entsprechend Anspruch 1, in dem das Mittel zum Ändern der Größe der Substrat RF Spannung in Bezug zur Größe der Quellenspannung ein änderbarer Kondensator (23) ist.

**3.** Ein ionenätzendes und/oder durch Zerstäuben beschichtendes RF Gerät entsprechend Anspruch 1 oder 2, in dem die zusätzliche Elektrode (15) von einem Anschluß eines RF Generators (13) gesteuert wird und die Quellen- und Substratelektrode (17 oder 21) den Rückweg festlegen.

**4.** Ein ionenätzendes und/oder durch Zerstäuben beschichtendes RF Gerät entsprechend einem der Ansprüche 1 bis 3, in dem die Quellenelektrode (17) und Substratelektrode (21) die angesteuerten Elektroden sind und die zusätzliche Elektrode (15) den Rückweg festlegt.

**5.** Ein nicht-reaktives ionenätzendes und/oder durch Zerstäuben beschichtendes RF Gerät mit einer RF Spannungquelle (13), einer Vakuumkammer (19), die eine Substratelektrode und eine Quellenelektrode (21 oder 17) so umschließt, daß die Quellenelektrode und die Substratelektrode sich gegenüberliegen, einer zusätzlichen Elektrode (15), die die Quellen- und Substratelektroden (17 oder 21) und den Raum zwischen ihnen umgibt, Mittel zum Versorgen mit und ändern von RF Spannungspotentialen, die an die Quellenelektrode, Substratelektrode und zusätzliche Elektrode (17, 21 oder 15) angelegt sind und wobei die Kammer (19) Mittel zum Einführen eines ionisierbaren Gases in die Kammer enthält, dadurch gekennzeichnet daß:

- die zusätzliche Elektrode (15) getrennt ist von der Vakuumkammer (19)
- die zusätzliche Elektrode (15) eine Fläche hat, die ungefähr gleich ist der Fläche der Substratelektrode (21) und
- die RF Spannung so angelegt ist, daß die Phasenbeziehung zwischen den Potentialen der Quellen- und Substratelektroden (17 oder 21) fast $180^{\circ}$ beträgt.

**6.** Ein ionenätzendes und/oder durch Zerstäuben beschichtendes RF Gerät entsprechend Anspruch 5, in dem das Mittel zum Ändern der Größe der Substrat RF Spannung in Bezug zur Größe der Quellenspannung ein induktives Netzwerk (11) ist.

**7.** Ein ionenätzendes und/oder durch Zerstäuben beschichtendes RF Gerät entsprechend den Ansprüchen 5 oder 6, in dem die zusätzliche Elektrode (15) und die Substratelektrode (21) von einem Anschluß eines RF Generators (13) gesteuert werden und die Quellenelektrode (17) den Rückweg festlegt.

**8.** Ein ionenätzendes und/oder durch Zerstäuben beschichtendes RF Gerät entsprechend einem der Ansprüche 5 bis 7, in dem die Quellenelektrode (17) die angesteuerte Elektrode ist und die Substratelektrode (21) und die zusätzliche Elektrode (15) den Rückweg festlegen.

**9.** Ein ionenätzendes und/oder durch Zerstäuben beschichtendes RF Gerät entsprechend einem der Ansprüche 1 bis 8, in dem die Mittel zum Einführen des Gasstromes in die Vakuumkammer (19) aus einer kreisförmigen, die Substratelektrode (21) umgebenden Sammelleitung bestehen.

**10.** Ein ionenätzendes und/oder durch Zerstäuben beschichtendes RF Gerät entsprechend Anspruch 1, in dem das in die Vakuumkammer (19) einzuführende Gas aus der Gruppe der Edelgase, bevorzugt aus der Gruppe bestehend aus Argon, Xenon oder Krypton, ausgewählt wird.

10

# FIG.1
## PRIOR ART

FIG.2

FIG.3

FIG.4

# FIG.5

ARGON FLOW — SCCM

[1.333 μbar]
([mT])

| FLOW SCCM | CHAMBER PRESSURE [1.333 μbar] | OUTER CHAMBER PRESSURE [1.333 μbar] |
|---|---|---|
| 0 | 0 | 0 |
| 1 | 3 | 0.81 |
| 2 | 8 | 1.6 |
| 3 | 14 | 2.41 |
| 4 | 19 | 3.2 |
| 5 | 25 | 4.01 |
| 6 | 31 | 4.81 |
| 7 | 37 | 5.6 |
| 8 | 43 | 6.39 |
| 9 | 49 | 7.17 |
| 10 | 54 | 7.94 |
| 11 | 60 | 8.7 |
| 12 | 66 | 9.46 |
| 13 | 72 | 10.21 |
| 14 | 77 | 10.97 |
| 15 | 83 | 11.71 |
| 16 | 89 | 12.43 |
| 17 | 94 | 13.16 |
| 18 | 100 | 13.88 |
| 19 | 105 | 14.59 |
| 20 | 110 | 15.3 |
| 21 | 116 | 16 |
| 22 | 121 | 16.7 |
| 23 | 127 | 17.39 |
| 24 | 132 | 18.09 |
| 25 | 137 | 18.77 |

EP 0 261 347 B1

FIG.6

DEPOSITION
RATE — nm/MIN

RF INPUT POWER — WATTS

62
63

FIG.7

DEPOSITION
RATE—nm/MIN
TUNED
SUBSTRATE
MODE

RF INPUT POWER — WATTS

EP 0 261 347 B1

# FIG.8

EP 0 261 347 B1

# FIG.9

THICKNESS NORMALIZED TO CENTER

RADIAL DISTANCE ON WAFER — [2.54 cm] ([INCH])

69.1A

69.1B

EP 0 261 347 B1

FIG.10

THICKNESS
NORMALIZED
TO CENTER

RADIAL DISTANCE ON WAFER — [2.54 cm] ([INCH])

EP 0 261 347 B1

FILM THICKNESS
NORMALIZED TO CENTER
OF SYSTEM

FIG.11.1

RADIAL THICKNESS FROM CENTER OF WAFER — [2.54 cm] (CINCH)

EP 0 261 347 B1

FILM THICKNESS
NORMALIZED TO CENTER
OF SYSTEM
(WALL DEPOSIT)

FIG.11.2

RADIAL THICKNESS FROM CENTER OF SYSTEM — [2.54 cm] ([INCH])

EP 0 261 347 B1

FIG.12

PEAK HEIGHT IN
μm OVER 1.0 μm
METAL

POWER = 3.0 KW.

SiO₂ THICKNESS = 2.4 μm

LINE WIDTH IN μm

EP 0 261 347 B1